# EUROPEAN PATENT APPLICATION

(11) **EP 2 262 352 A1**
(43) Date of publication of application: **15.12.2010**
(21) Application number: 09725063.3
(22) Date of filing: 12.03.2009
(51) Int. Cl.: H05K 3/46, H05K 3/28

(54) **METHOD FOR PRODUCING RIGID-FLEX CIRCUIT BOARD, AND RIGID-FLEX CIRCUIT BOARD**

(30) Priority: 25.03.2008 JP 2008077140
(71) Applicant: Sumitomo Bakelite Co., Ltd., Shinagawa-ku Tokyo 140-0002 (JP)
(72) Inventor: YAMATO, Hajime, Akita-shi Akita 011-8510 (JP)
(74) Representative: Müller, Christian Stefan Gerd
(86) International application number: PCT/JP2009/001110
(87) International publication number: WO 2009/119027

(57) **Abstract**

A method of manufacturing a rigid-flex circuit board includes preparing a first and a second coverlay film (200, 250), and a first and a second circuit substrate (100, 150) having a first and a second circuit (103, 153) formed thereon, and a first interlayer adhesive sheet (300); Stacking the first coverlay film (200), the first circuit substrate (100) disposed such that the first circuit (103) opposes the first coverlay film (200), the first interlayer adhesive sheet (300) located in a region where a rigid portion (700) is to be formed, the second coverlay film (250), and the second circuit substrate (150) disposed such that the second circuit (153) opposes the second coverlay film (250), and executing a heat-pressing process.

## Description

### TECHNICAL FIELD

The present invention relates to a method of manufacturing a rigid-flex circuit board, and to the rigid-flex circuit board.

### BACKGROUND ART

Because of recent progress in integration density of electronic apparatuses, flexible circuit boards employed therein have come to be manufactured in greater number of layers, with finer wirings, and in higher density.
The flexible circuit boards can be broadly classified into a rigid-flex circuit board which is a composite substrate constituted of a flexible circuit portion and a rigid circuit portion, and a multilayer flexible wiring board constituted of flexible circuit boards laminated in multiple layers.

In the conventional rigid-flex circuit board, the flexible portion includes a plurality of flexible circuit portions, and the rigid portion includes a plurality of layers of flexible circuit portions and rigid circuit portions, stacked and bonded with each other (for example, patent document 1).

Amount of information required for the rigid-flex circuit board and the specification thereof are changing year after year. The flexible circuit portion connecting the rigid circuit portions is of a single-sided structure constituted of a single-sided flexible laminated plate for securing flexibility, on which a conductor circuit is provided only on one side thereof. In the case of employing a double-sided flexible laminated plate, a pseudo single-sided specification is adopted in which the flexible portion provided the conductor circuit only on one side, while the rigid portion is of a double-sided structure. The pseudo single-sided specification means a structure including the double-sided flexible laminated plate, but from which a metal foil on one side is removed by etching or the like, so that it appears as if the conductor circuit were provided only on one side. However, the increase in information amount is presenting the problem that, while the single-sided structure is unable to provide a sufficient number of wirings, employing the double-sided structure or the multilayer structure for the flexible portion leads to remain the unresolved problem of flexibility. Also, in the case of adopting the pseudo single-sided specification for the flexible portion, the drawback arises that although a sufficient number of layers for coping with the increase in information amount can be secured in the rigid portion by employing the double-sided conductor circuit, it is difficult to achieve an appropriate balance with the flexible portion.

As a solution of the foregoing, a manufacturing method is employed whereby a plurality of single-sided flexible circuit boards is stacked in a necessary number of layers. By the manufacturing method, firstly the conductor circuit of the metal foil is formed on the single-sided flexible laminated plate. Then a coverlay film is superposed for protecting the circuit, and the plate is heat-pressed via an adhesive provided on the coverlay film, so that the single-sided flexible circuit board is obtained. Such process is repeated until the predetermined number of layers for the flexible portion is formed. An interlayer adhesive sheet is placed in the region on the single-sided flexible circuit board thus prepared where the rigid portion is to be formed, and these are collectively heat-pressed for lamination. Thereafter, an outer-layer circuit and so forth are formed, so that the rigid-flex circuit board is obtained (for example, patent document 2).

However, the foregoing method includes many processes that employ heat, such as the heat-press lamination of the coverlay film on the respective circuit boards and the collective lamination for forming the multilayer structure. Such method incurs difficulty in adjusting the positional relationship between the layers because of fluctuation in size change of the respective circuit boards and warp of the circuit substrate, thereby degrading the interlayer connection reliability of the rigid-flex circuit board. Besides, the plurality of heat-press bonding processes leads to lowered yield of the products and increase in man-hour.
[Patent document 1] JP-A No.H06-021653
[Patent document 2] JP-A No.2007-134550

### DISCLOSURE OF THE INVENTION

The present invention has been accomplished in view of the foregoing situation, and provides a method of manufacturing a rigid-flex circuit board that is highly reliable in interlayer connection and that contributes to improving the yield and reducing the cost, and the rigid-flex circuit board thereby manufactured.

According to the present invention, there is provided a method of manufacturing a rigid-flex circuit board that includes a flexible portion and a rigid portion, comprising preparing a first circuit substrate having a first circuit formed on a surface thereof, a first coverlay film to be provided over the first circuit, a second circuit substrate having a second circuit on a surface thereof, a second coverlay film to be provided over the second circuit, and a first interlayer adhesive sheet; placing the first circuit substrate and the first coverlay film on one side of the first interlayer adhesive sheet provided in a region where the rigid portion is to be formed, and the second circuit substrate and the second coverlay film on the other side of the first interlayer adhesive sheet; and placing the first coverlay film on the side of the first circuit and the second coverlay film on the side of the second circuit, and collectively executing a heat-pressing process upon stacking the circuit substrates, the coverlay films and the interlayer adhesive sheet.

By the manufacturing method of the rigid-flex circuit board thus arranged, the respective materials constituting the rigid-flex circuit board are stacked in a predetermined order, and the stacked materials are collectively subjected to the heat-press bonding process. Such method minimizes the number of times of the heat-press bonding for the respective layers thereby suppressing the fluctuation in size between the layers, thus resulting in manufacturing the rigid-flex circuit board highly reliable in interlayer connection. Further, the manufacturing method of the rigid-flex circuit board, and the rigid-flex circuit board thereby manufactured contribute, with the advantage of reduced number of times of the heat-press bonding, to reducing the environmental impact, improving the yield, and reducing the man-hour.

Thus, the present invention provides a method of manufacturing a rigid-flex circuit board that is highly reliable in interlayer connection, and that contributes to improving the yield and reducing the cost, and the rigid-flex circuit board thereby manufactured.

### BRIEF DESCRIPTION OF THE DRAWINGS

The above and other objects, features, and advantages will become more apparent through the preferred embodiments described hereunder and the accompanying drawings.
Fig. 1 is a cross-sectional view for explaining a method of manufacturing a two-layered rigid-flex circuit board according to an embodiment;
Fig. 2 is another cross-sectional view for explaining the method of manufacturing the two-layered rigid-flex circuit board according to the embodiment;
Fig. 3 is still another cross-sectional view for explaining the method of manufacturing the two-layered rigid-flex circuit board according to the embodiment;
Fig. 4 is still another cross-sectional view for explaining the method of manufacturing the two-layered rigid-flex circuit board according to the embodiment;
Fig. 5 is still another cross-sectional view for explaining the method of manufacturing the two-layered rigid-flex circuit board according to the embodiment;
Fig. 6 is a cross-sectional view of the two-layered rigid-flex circuit board according to the embodiment;
Fig. 7 is a cross-sectional view for explaining a method of manufacturing a three-layered rigid-flex circuit board according to another embodiment;
Fig. 8 is another cross-sectional view for explaining the method of manufacturing the three-layered rigid-flex circuit board according to the another embodiment;
Fig. 9 is a cross-sectional view of the three-layered rigid-flex circuit board according to the another embodiment;
Fig. 10 is a cross-sectional view for explaining a method of manufacturing a four-layered rigid-flex circuit board according to still another embodiment;
Fig. 11 is another cross-sectional view for explaining the method of manufacturing the four-layered rigid-flex circuit board according to the still another embodiment;
Fig. 12 is a cross-sectional view of the four-layered rigid-flex circuit board according to the still another embodiment;
Fig. 13 is a cross-sectional view for explaining a method of manufacturing a three-layered rigid-flex circuit board according to still another embodiment;
Fig. 14 is another cross-sectional view for explaining the method of manufacturing the three-layered rigid-flex circuit board according to the still another embodiment;
Fig. 15 is a cross-sectional view of the three-layered rigid-flex circuit board according to the still another embodiment;
Fig. 16 is a cross-sectional view for explaining a method of manufacturing a six-layered rigid-flex circuit board according to still another embodiment;
Fig. 17 is another cross-sectional view for explaining the method of manufacturing the six-layered rigid-flex circuit board according to the still another embodiment;
Fig. 18 is still another cross-sectional view for explaining the method of manufacturing the six-layered rigid-flex circuit board according to the still another embodiment;
Fig. 19 is a plan view for explaining the method of manufacturing the two-layered rigid-flex circuit board according to the embodiment; and
Figs. 20(a) and 20(b) are another plan views for explaining the method of manufacturing the two-layered rigid-flex circuit board according to the embodiment.

### BEST MODE FOR CARRYING OUT THE INVENTION

Hereunder, a rigid-flex circuit board, as well as a manufacturing method thereof according to the present invention will be described in details.

### [First embodiment]

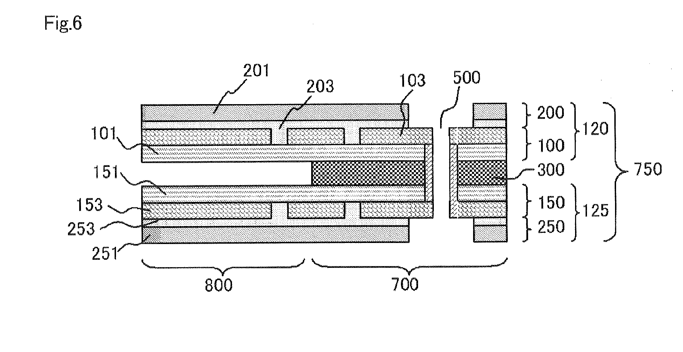

A first embodiment refers to a manufacturing method of a two-layered rigid-flex circuit board 750 shown in Fig. 6.

The rigid-flex circuit board 750 is of a two-layered structure including a flexible portion 800 and a rigid portion 700.

The flexible portion 800 is constituted of a first flexible circuit portion 120 that includes a first circuit substrate 100 including a first base material 101 and a first circuit 103 formed thereon, and a first coverlay film 200 provided over the first circuit 103 such that a portion thereof remains uncovered; and a second flexible circuit portion 125 that includes a second circuit substrate 150 including a second base material 151 and a second circuit 153 formed thereon, and a second coverlay film 250 provided over the second circuit 153 such that a portion thereof remains uncovered; the first flexible circuit portion 120 and the second flexible circuit portion 125 being disposed so as to oppose each other. The rigid portion 700 is constituted of the first base material 101 and the second base material 151 extending to a region where the rigid portion 700 is to be located, and where the first base material 101 and the second base material 151 are joined via the interlayer adhesive sheet 300. The coverlay films 200, 250 are constituted of a resin film 201, 251 and an adhesive 203, 253, respectively.

In the rigid portion 700, the first and the second flexible circuit portion 120, 125 are joined via the interlayer adhesive sheet 300. The rigid portion 700 also includes a through hole 500 formed throughout the layers for achieving electrical connection between the respective layers. The flexible portion 800 is constituted of the first and the second flexible circuit portion 120, 125. Although the rigid portion 700 is provided only on the right side in Fig. 6, the rigid portion may be formed at a plurality of locations if necessary. The circuit portions 120, 125 may be disposed in contact with each other or spaced from each other. Here, although the first and the second flexible circuit portion 120, 125 include the same circuit and the same coverlay film in Fig. 6, different circuits may be provided. Likewise, different materials may be employed for the interlayer adhesive sheet 300 according to the condition (for example, fluctuation in size and heat resistance).

The manufacturing method of the two-layered rigid-flex circuit board 750 will be described hereunder.

The manufacturing method of the rigid-flex circuit board 750 including the flexible portion 800 and the rigid portion 700 according to the present invention may be executed as the following steps.

### [Step A]

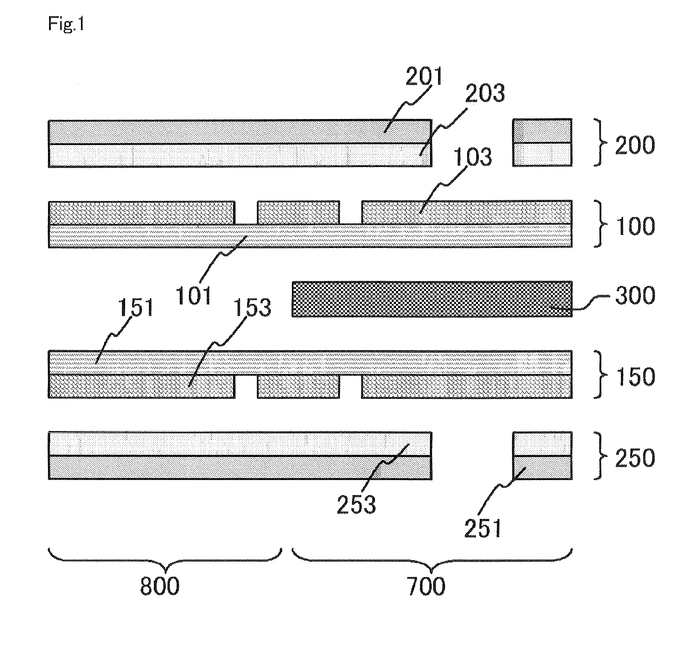

Referring to Fig. 1, a step A will be described. The step A includes preparing the first and the second coverlay film 200, 250; the first and the second circuit substrate 100, 150 including the first and the second base material 101, 151 and the first and the second circuit 103, 153 formed thereon respectively; and the first interlayer adhesive sheet 300.

First, the first and the second circuit substrate 100, 150 are formed. The circuits 103, 153 of a desired pattern are formed, for example by etching, on a metal foil of a laminated plate constituted of the base material 101, 151 and the metal foil provided on one of the faces thereof, so that the first and the second circuit substrate 100, 150 are obtained.
The base material 101, 151 may be constituted of, for example, a resin film base material. Examples of the resin film base material include a polyimide resin-based film such as a polyimide resin film, a polyetherimide resin film, or a polyamide-imide resin film, a polyamide resin-based film such as a polyamide resin film, and a polyester resin-based film such as a polyester resin film. Among those, it is preferable to primarily employ the polyimide resin-based film, which provides a improvement of elastic modulus and heat resistance, in particular.

Although the thickness of the base material 101, 151 is not specifically limited, it is preferable that the thickness is 5 to 50 µm, and more preferably 12.5 to 25 µm (hereinafter, a range indicated by "to" includes both the upper and lower limit, unless otherwise specified). The thickness within such range provides high bendability, in particular.

The metal foil may be constituted of iron, aluminum, stainless steel, copper, and so forth. Among those, it is preferable to employ copper as the metal foil, from the viewpoint of electrical characteristic. Although the thickness of the metal foil is not specifically limited, it is preferable that the thickness is 5 to 35 µm, and more preferably 8 to 18 µm.

Then the first and the second coverlay film 200, 250 are prepared in order to correspond to the first and the second circuit 103, 153 respectively. The first and the second coverlay film 200, 250 are formed by, applying an adhesive to a resin film, for example. Otherwise, an ink may be directly printed on the base material. In the structure shown in Figs. 1 to 4, the first and the second coverlay film 200, 250 are formed by applying an adhesive 203, 253 to a resin film 201, 251.

Examples of the resin film 201, 251 include, as the base material specified above, a polyimide resin-based film such as a polyimide resin film, a polyetherimide resin film, or a polyamide-imide resin film, a polyamide resin-based film such as a polyamide resin film, and a polyester resin-based film such as a polyester resin film. Among those, it is preferable to primarily employ the polyimide resin-based film, which provides a improvement of elastic modulus and heat resistance, in particular. Here, it is preferable that the first and the second coverlay film 200, 250 cover the entirety of the circuit 103, 153.

It is preferable that each of the adhesive 203, 253 is constituted of a resin composition containing a thermosetting resin such as an epoxy-based resin, a polyester-based resin, a polyimide-based resin, a polyamide-based resin, a polyamide-imide-based resin, or a polyurethane-based resin. Among those, it is preferable to employ the epoxy-based resin. Such material contributes to improve close adhesion, and also heat resistance.

### [Step B]

Thereafter, the first circuit substrate 100 and the first coverlay film 200 are located in this order on one of the faces of the first interlayer adhesive sheet 300, and the second circuit substrate 150 and the second coverlay film 250 in this order on the other face thereof, in the region where the rigid portion 700 is to be formed, such that the first coverlay film 200 is stacked on the side of the first circuit 103, and the second coverlay film 250 on the side of the second circuit 153.

Examples of the material constituting the first interlayer adhesive sheet 300 include a thermosetting resin such as an epoxy-based resin, and a polyimide-based resin, a polyamide-imide-based resin, an acrylic-based resin, a polyurethane-based resin, a polyester-based resin, and so forth. Among those, it is preferable to employ the epoxy-based resin. Such material contributes to improve close adhesion and heat resistance. Alternatively, the first interlayer adhesive sheet 300 may be a pre-preg constituted of a glass fiber base material impregnated with the thermosetting resin.

It is preferable that the first interlayer adhesive sheet 300 has a thickness of 10 to 200 µm, or 20 to 120 µm in the case of employing the pre-preg, or 10 to 100 µm in the case of employing a bonding sheet. Also, since the plurality of layers is collectively laminated upon being layered as above, the rigid portion 700 has a greater overall thickness than the flexible portion 800 which does not include the interlayer adhesive sheet. Accordingly, it is preferable that the interlayer adhesive sheet is thinner.

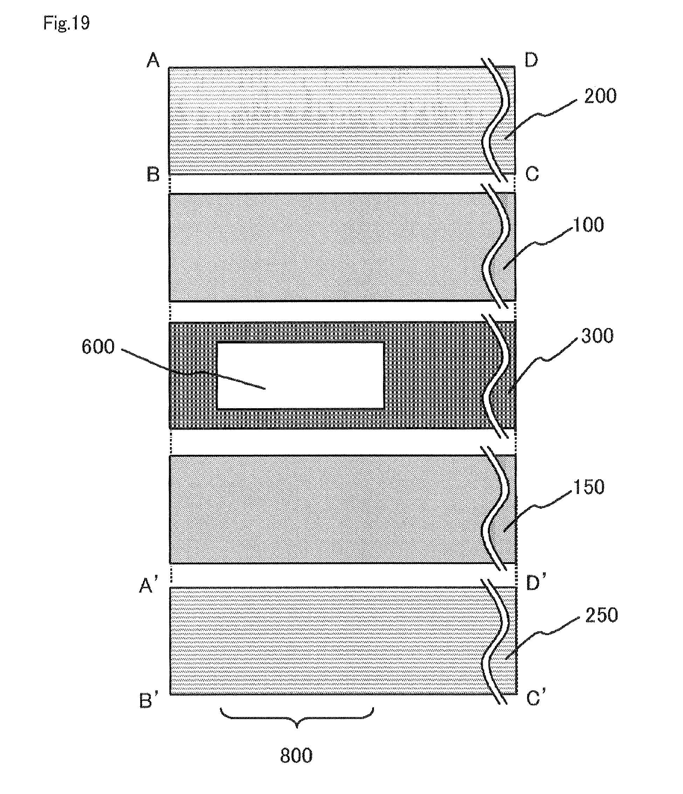

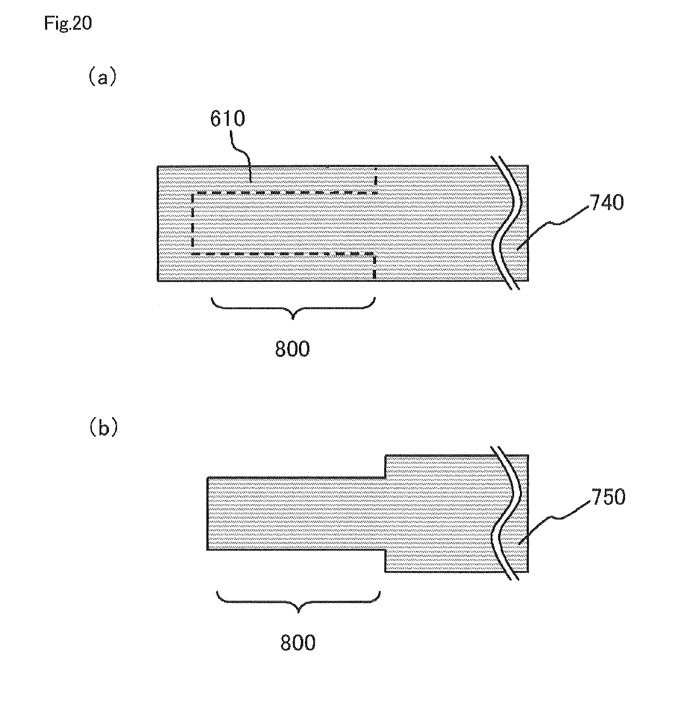

The first interlayer adhesive sheet 300 thus prepared is punched by a die or the like, so as to remove the portion thereof corresponding to the region of the flexible portion 800 of the rigid-flex circuit board 750, to thus obtain the first interlayer adhesive sheet 300 having an opening 600 (Fig. 19). Through such process, two rigid portions 700 spaced across the flexible portion 800 can be formed. In the punching process it is preferable to leave, in a form of a bridge, a peripheral portion of the interlayer adhesive sheet which is not utilized in the product, from the viewpoint of work efficiency in the manufacturing process (Fig. 20(a)).

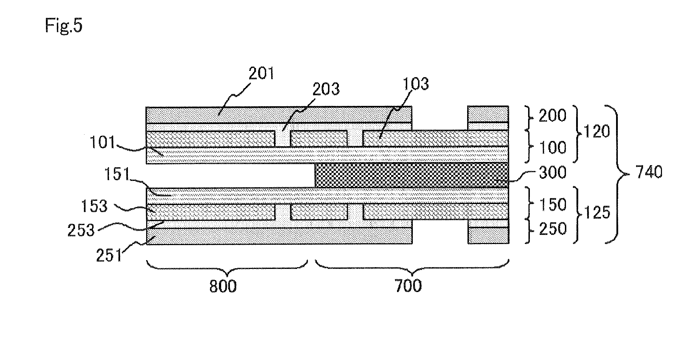

Then heat-press bonding is executed, upon stacking the first coverlay film 200 on the side of the first circuit 103, and the second coverlay film 250 on the side of the second circuit 153 (Fig. 5).

It is preferable to set the temperature at 110 to 220°C, and the pressure at 0.2 to 10 MPa, and to employ a heat-press machine for collective heat-press bonding.

Through the foregoing process, a two-layered intermediate plate 740 can be obtained (Fig. 5). Here, the intermediate plate 740 includes the first flexible circuit portion 120 and the second flexible circuit portion 125 with the first interlayer adhesive sheet 300 interleaved therebetween. It is to be noted that although the first flexible circuit portion 120 and the second flexible circuit portion 125 are constituted of the same materials, different materials may be employed.

### [Step C]

Then the two-layered rigid-flex circuit board 750 is formed as shown in Fig. 6.

In the two-layered intermediate plate 740 (Fig. 5) obtained through the step B, a through hole 500 may be formed so as to penetrate through all the layers for electrical connection (Fig. 6). To form the through hole 500, an NC drilling machine or a laser may be employed. Also, on the region where the coverlay film 200, 250 have been removed and the circuit 103, 153 are exposed, a metal coating layer may be provided if necessary. The metal coating layer prevents contamination of the circuit surface. The metal coating layer may be constituted of a metal or an alloy. Although the metal to be employed is not specifically limited, tin is preferable because of its low melting point. Preferable alloys include a solder composed of at least two metals selected from tin, lead, silver, zinc, bismuth, antimony, and copper. Examples of such solder include a tin-lead-based one, a tin-silver-based one, a tin-zinc-based one, a tin-bismuth-based one, a tin-antimony-based one, a tin-silver-bismuth-based one, and a tin-copper-based one, however an optimal one may be adopted without limitation to the foregoing combination or composition of the solder.

Through the foregoing process, the two-layered rigid-flex circuit board 750 can be obtained (Fig. 6).

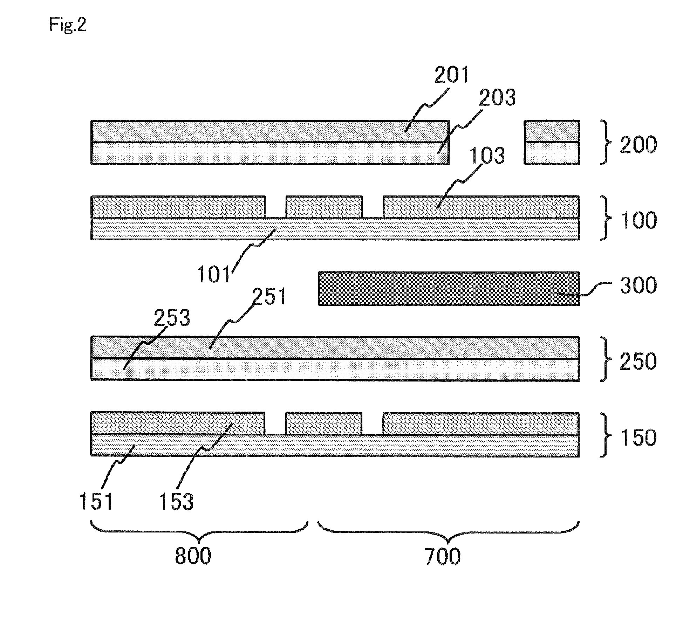

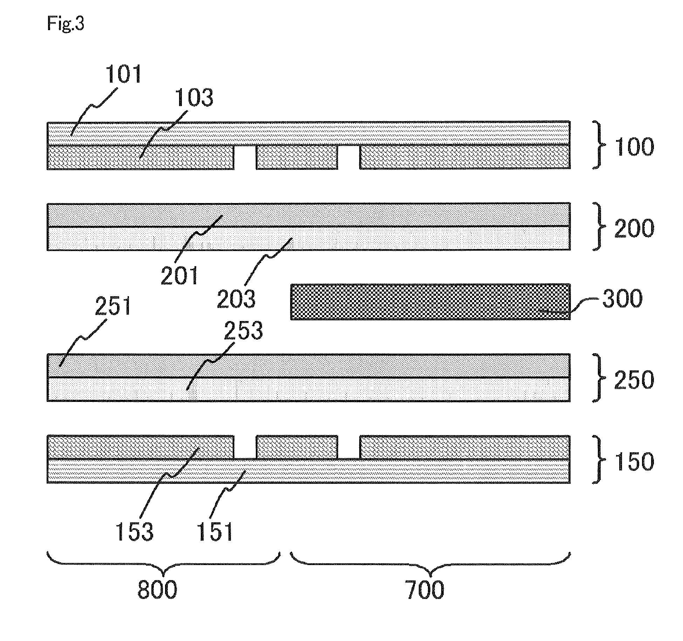

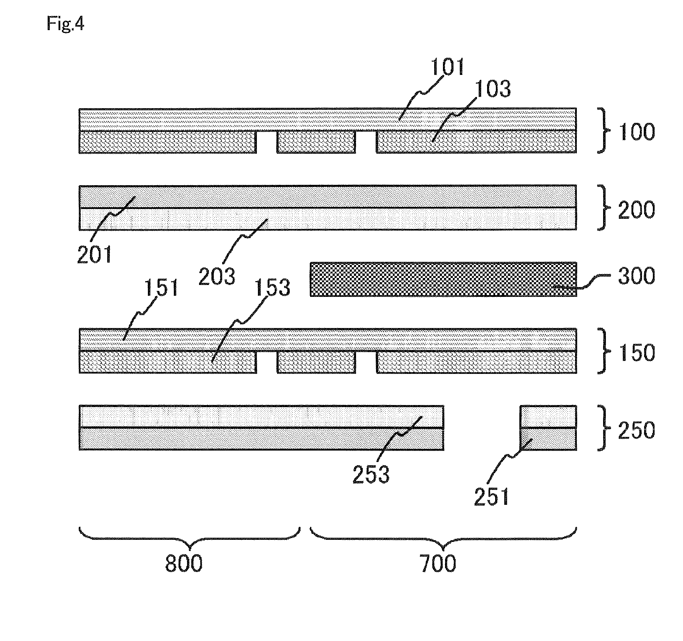

Although the first embodiment has been described referring to the structure shown in Fig. 1, a different structure may be adopted. In other words, the location of the circuit substrates 100, 150, and the coverlay films 200, 250 is not limited. The structure may be arranged in four patterns as exemplified below, each of which may be adopted as the case may be.
(A) The first base material 101 and the second base material 151 oppose each other through the first interlayer adhesive sheet 300 (Fig. 1).
(B) The first base material 101 and the second coverlay film 250 oppose each other through the first interlayer adhesive sheet 300 (Fig. 2).
(C) The first coverlay film 200 and the second coverlay film 250 oppose each other through the first interlayer adhesive sheet 300 (Fig. 3).
(D) The first coverlay film 200 and the second base material 151 oppose each other through the first interlayer adhesive sheet 300 (Fig. 4).

Further, a manufacturing process of the flexible portion 800 according to this embodiment will be described in details hereunder.
First, as shown in Fig. 19, the first coverlay film 200, the first circuit substrate 100, the first interlayer adhesive sheet 300 including the opening 600 formed therein, the second circuit substrate 150, and the second coverlay film 250 are prepared and stacked in this order, and the heat-press bonding is executed under such state. Through this process the two-layered intermediate plate 740 is obtained.
Then cutting slits are formed in a projecting shape on the two-layered intermediate plate 740 as shown in Fig. 20(a), and an unnecessary portion 610 is removed. To form the cutting slits, for example a punching die may be employed. Through this process, the flexible portion 800 can be formed on the upper side and the lower side of the first interlayer adhesive sheet 300, respectively.
Upon thus forming the flexible portion 800, the two-layered rigid-flex circuit board 750 according to this embodiment can be obtained.

### [Second embodiment]

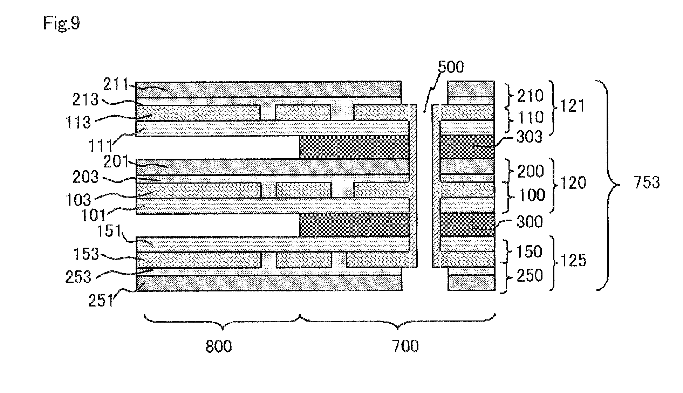

A second embodiment refers to a manufacturing method of a three-layered rigid-flex circuit board 753 shown in Fig. 9.

As shown in Fig. 9, the rigid-flex circuit board 753 is of a three-layered structure including the flexible portion 800 and the rigid portion 700.

The flexible portion 800 is constituted of a first flexible circuit portion 120 that includes a first circuit substrate 100 including a first base material 101 and a first circuit 103 formed thereon, and a first coverlay film 200 provided over the first circuit 103 such that a portion thereof remains uncovered; a second flexible circuit portion 125 that includes a second circuit substrate 150 including a second base material 151 and a second circuit 153 formed thereon, and a second coverlay film 250 provided over the second circuit 153 such that a portion thereof remains uncovered, the first flexible circuit portion 120 and the second flexible circuit portion 125 being disposed so as to oppose each other; and a third flexible circuit portion 121 located so as to oppose the coverlay film 200 of the first flexible circuit portion 120, through a third interlayer adhesive sheet 303.
The rigid portion 700 is constituted of the first, the second and the third base material 101, 151, 111 extending to a region where the rigid portion 700 is to be located, and where the first, the second, and the third base material 151 are joined through the first and the third interlayer adhesive sheet 300. The first, the second and the third coverlay films 200, 250, 210 are constituted of a resin film 201, 251, 211 and an adhesive 203, 253, 213 respectively.

In the rigid portion 700, the first, the second, and the third flexible circuit portion 120, 125, 121 are joined through the first and the third interlayer adhesive sheet 300, 303. The rigid portion 700 also includes a through hole 500 formed throughout the layers for achieving electrical connection between the respective layers 120, 125, 121. The flexible portion 800 is constituted of the first, the second, and the third flexible circuit portion 120, 125, 121. Although the rigid portion 700 is provided only on the right side in Fig. 9, the rigid portion may be formed at a plurality of locations if necessary. The circuit portions may be disposed in contact with each other or spaced from each other. Here, although the first, the second, and the third flexible circuit portion 120, 125, 121 include the same circuit and the same coverlay film in Fig. 9, different circuits may be provided.

The manufacturing method of the three-layered rigid-flex circuit board 753 will be described hereunder, which is similar to the foregoing manufacturing method of the two-layered rigid-flex circuit board 750, except that the third interlayer adhesive sheet 303, third circuit substrate 110, and the third coverlay film 210 are provided on the side of the first coverlay film 200.

### [Step A]

In addition to the step A of the preceding embodiment, the third circuit substrate 110 having the third circuit 113, the third coverlay film 210 to be provided over the third circuit 113, and the third interlayer adhesive sheet 303 are further prepared.

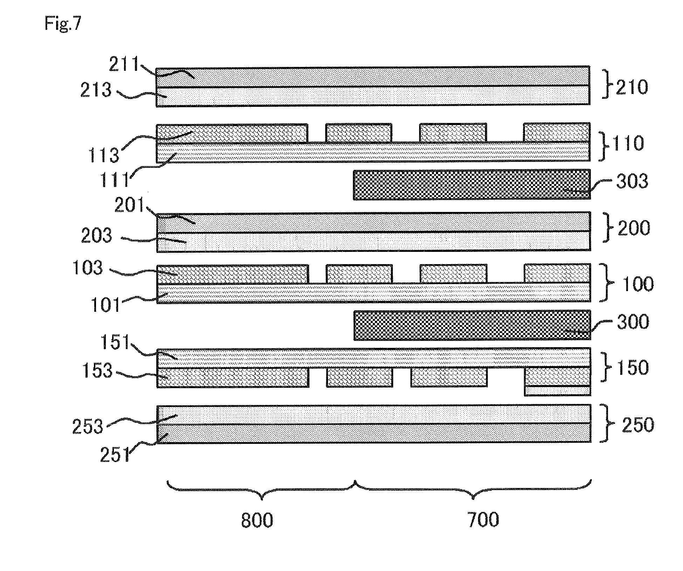

Then as shown in Fig. 7, the third coverlay film 210, the third circuit substrate 110, and the third interlayer adhesive sheet 303 provided only in a region where the rigid portion 700 is to be formed, are located in this order, and the first coverlay film 200, the first circuit substrate 100, and the first interlayer adhesive sheet 300 provided only in a region where the rigid portion 700 is to be formed, are located in this order, and further the second circuit substrate 150 and the second coverlay film 250 are located in this order, on the opposite side across the first interlayer adhesive sheet 300.

### [Step B]

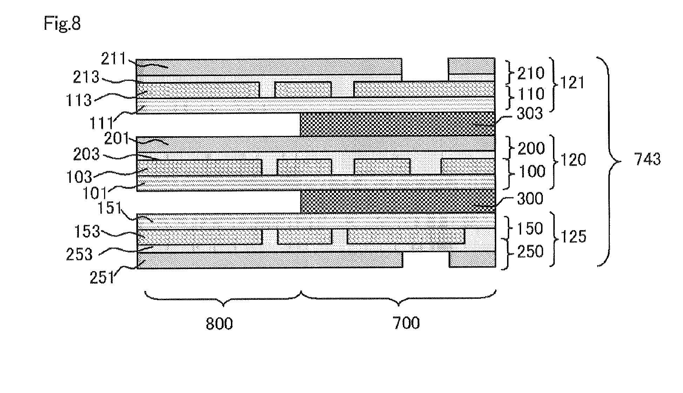

The stacked structure as shown in Fig. 7 is subjected to heat-press bonding (Fig. 8). Through such process, the three-layered intermediate plate 743 can be obtained.

### [Step C]

The step C is for forming the three-layered rigid-flex circuit board 753.
In the three-layered intermediate plate 743 (Fig. 8) obtained as above, a through hole 500 may be formed so as to penetrate through all the layers for electrical connection. Thus, the three-layered rigid-flex circuit board 753 can be obtained (Fig. 9).

### [Third embodiment]

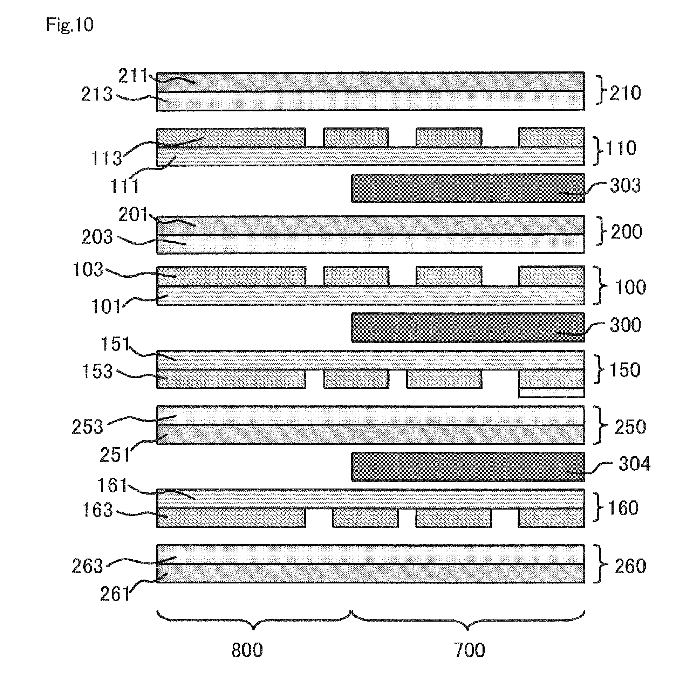

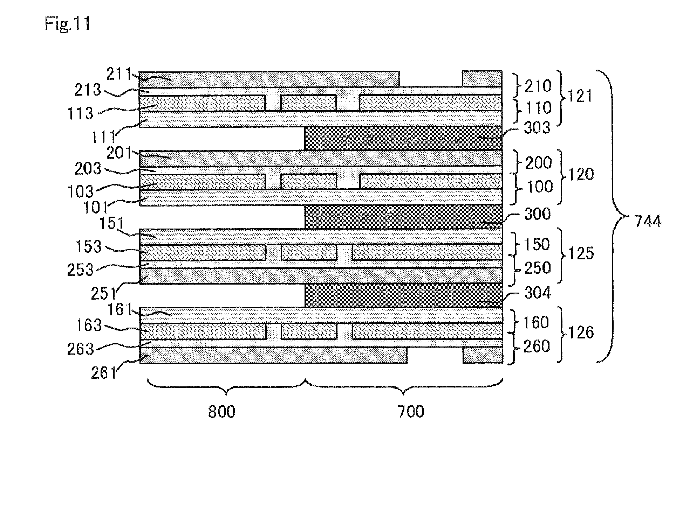

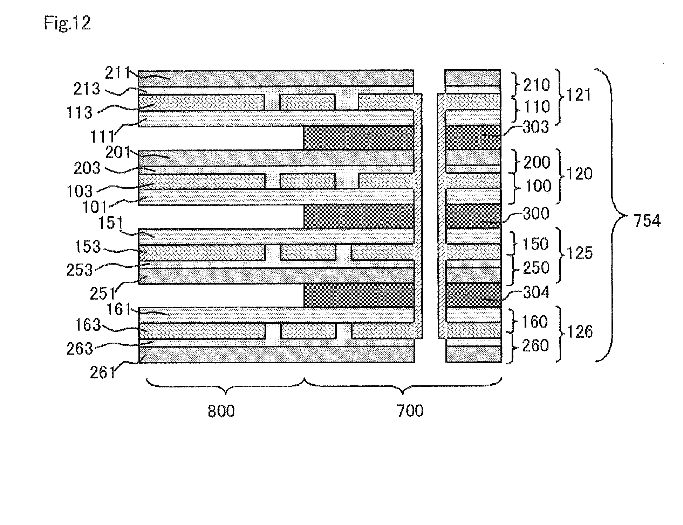

A third embodiment refers to a manufacturing method of a four-layered rigid-flex circuit board 754 shown in Fig. 12. Hereunder, the manufacturing method of the four-layered rigid-flex circuit board 754 will be described.
First, in addition to the step A of the preceding embodiment, a fourth circuit substrate 160 including a fourth circuit 163 and a fourth base material 161, a fourth coverlay film 260 including an adhesive 263 and a fourth resin film 261, and a fourth interlayer adhesive sheet 304 are further prepared.
Then the similarly stacked structure to the preceding embodiment, except that the fourth interlayer adhesive sheet 304, the fourth circuit substrate 160, and the fourth coverlay film 260 are located in this order on the side of the second coverlay film 250 (Fig. 10), is subjected to heat-press bonding (Fig. 11). Through such process, a four-layered intermediate plate 744 can be obtained (Fig. 11). In the four-layered intermediate plate 744 obtained as above, a through hole may be formed so as to penetrate through all the layers for electrical connection. Thus, the four-layered rigid-flex circuit board 754 can be obtained (Fig. 12).

The rigid-flex circuit board 754 shown in Fig. 12 is of a four-layered structure including the flexible portion 800 and the rigid portion 700.

The structure of the four-layered rigid-flex circuit board 754 is similar to that of the three-layered rigid-flex circuit board 753 according to the preceding embodiment, except that the fourth flexible circuit portion 126 is further joined to the third flexible circuit portion 125 via the fourth interlayer adhesive sheet 304.

### [Fourth embodiment]

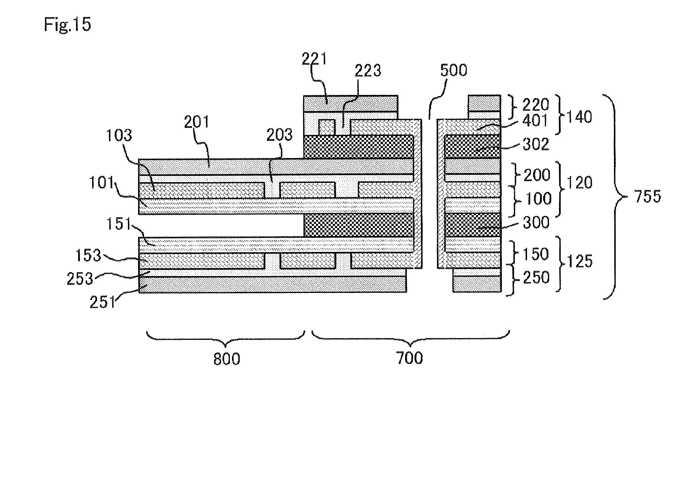

A fourth embodiment refers to a manufacturing method of a three-layered rigid-flex circuit board 755 shown in Fig. 15.

The rigid-flex circuit board 755 is of a three-layered structure including the flexible portion 800 and the rigid portion 700.

The flexible portion 800 is constituted of a first flexible circuit portion 120 that includes a first circuit substrate 100 including a first base material 101 and a first circuit 103 formed thereon, and a first coverlay film 200 provided over the first circuit 103 such that a portion thereof remains uncovered; a second flexible circuit portion 125 that includes a second circuit substrate 150 including a second base material 151 and a second circuit 153 formed thereon, and a second coverlay film 250 provided over the second circuit 153 such that a portion thereof remains uncovered, the first flexible circuit portion 120 and the second flexible circuit portion 125 being disposed so as to oppose each other. The rigid portion 700 is constituted of the first base material 101 and the second base material 151 extending to a region where the rigid portion 700 is to be located, and where the first base material 101 and the second base material 151 are joined via the interlayer adhesive sheet 300. The coverlay films 200, 250 are constituted of a resin film 201, 251 and an adhesive 203, 253, respectively. Further, a conductor circuit 401 and a surface coating layer 220 constitute a first conductor circuit portion 140.

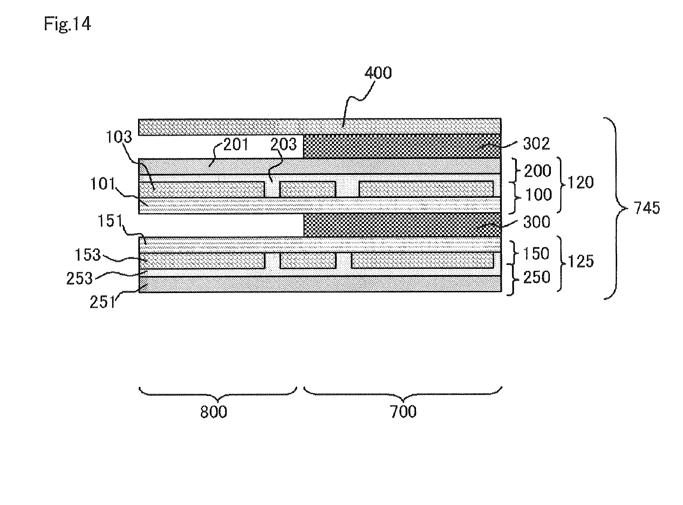

The rigid portion 700 includes a conductor circuit 401 (Fig. 15), formed as an outermost layer through executing an etching process or the like on a metal foil 400 (Fig. 14) stacked via a second interlayer adhesive sheet 302. The conductor circuit 401 formed on the rigid portion 700 may have its surface covered with a surface coating layer 220 (Fig. 15). The surface coating layer 220 may be a coverlay film constituted of a resin film 221 and an adhesive 223, or may be formed from a liquid resin composition containing a thermosetting resin by screen-printing and curing by heat. Here, although the conductor circuit 401 formed by processing the metal foil 400 is provided on the outermost layer of only one side in Figs. 14 and 15, the conductor circuit 401 may be provided on both sides. Also, the first and the second flexible circuit portion 120, 125 are bonded via the first interlayer adhesive sheet 300. The through hole 500 is provided so as to penetrate through all the layers, for electrical connection between the respective layers 140, 120, 125. The flexible portion 800 includes the first and the second flexible circuit portion 120, 125. Although the rigid portion 700 is provided only on the right side in Fig. 15, the rigid portion may be formed at a plurality of locations if necessary. The circuit portions 120, 125 may be disposed in contact with each other or spaced from each other. Here, although the first and the second flexible circuit portion 120, 125 include the same circuit and the same coverlay film in Fig. 15, different circuits may be provided.

The manufacturing method of the three-layered rigid-flex circuit board 755 will be described hereunder, which is similar to the manufacturing method of the two-layered rigid-flex circuit board 750, except for the structure of the outermost layer.

### [Step A]

In addition to the step A of the first embodiment, the metal foil 400 and the second interlayer adhesive sheet 302 are further prepared.

The metal foil 400 may be constituted of iron, aluminum, stainless steel, copper, and so forth. Among those, it is preferable to employ copper as the metal foil 400, from the viewpoint of electrical characteristic. Although the thickness of the metal foil 400 is not specifically limited, it is preferable that the thickness is 5 to 35 µm, and more preferably 8 to 18 µm.

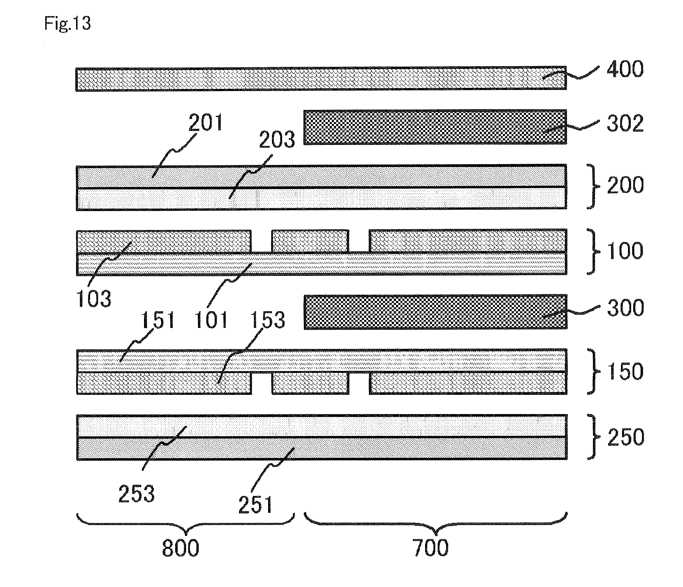

Then as shown in Fig. 13, the second interlayer adhesive sheet 302 and the metal foil 400 are located in this order in a region where the rigid portion 700 is to be formed, on the side of the first coverlay film 200.

### [Step B]

The structure thus stacked is subjected to heat-press bonding. Fig. 14 illustrates the three-layered intermediate plate 745 obtained through such process.

### [Step C]

The step C is for forming the three-layered rigid-flex circuit board 755.
The through hole 500 may be formed so as to penetrate through all the layers for electrical connection. It is preferable to entirely remove the metal foil 400 in the region where the flexible portion 800 is to be formed, when forming the conductor circuit 401 by etching or the like. To form the through hole 500, an NC drilling machine or a laser may be employed. Also, on the region where the surface coating layer 220 has been removed and the conductor circuit 401 is exposed, a metal coating layer may be provided if necessary. The metal coating layer prevents contamination of the circuit surface. The metal coating layer may be constituted of a metal or an alloy. Although the metal to be employed is not specifically limited, tin is preferable because of its low melting point. Preferable alloys include a solder composed of at least two metals selected from tin, lead, silver, zinc, bismuth, antimony, and copper. Examples of such solder include a tin-lead-based one, a tin-silver-based one, a tin-zinc-based one, a tin-bismuth-based one, a tin-antimony-based one, a tin-silver-bismuth-based one, and a tin-copper-based one, however an optimal one may be adopted without limitation to the foregoing combination or composition of the solder.

Thus, the three-layered rigid-flex circuit board 755 can be obtained (Fig. 15).

### [Fifth embodiment]

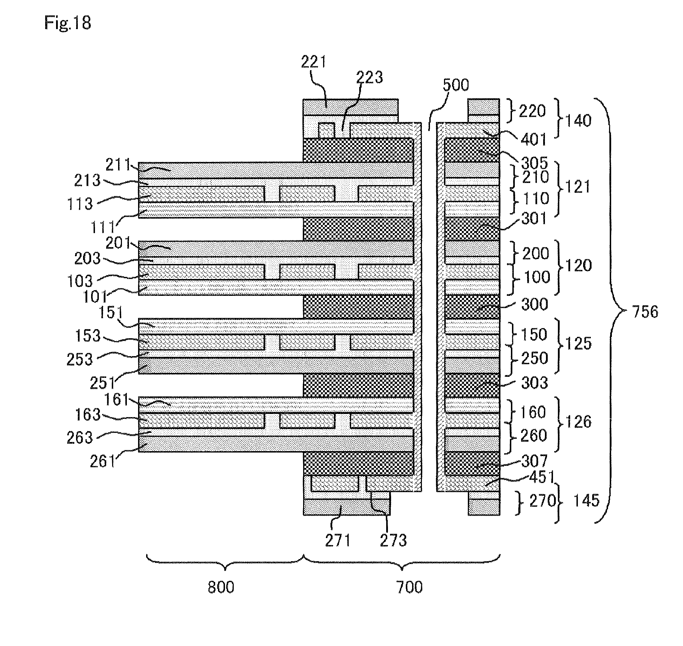

A fifth embodiment refers to a manufacturing method of a six-layered rigid-flex circuit board 756 shown in Fig. 18.

As shown in Fig. 18, the rigid-flex circuit board 756 is of a six-layered structure including the flexible portion 800 and the rigid portion 700.

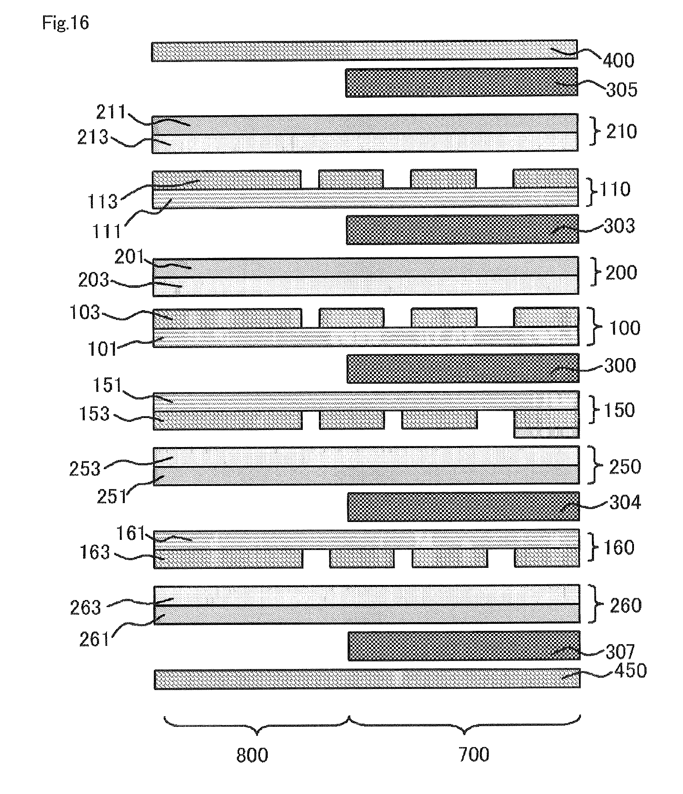

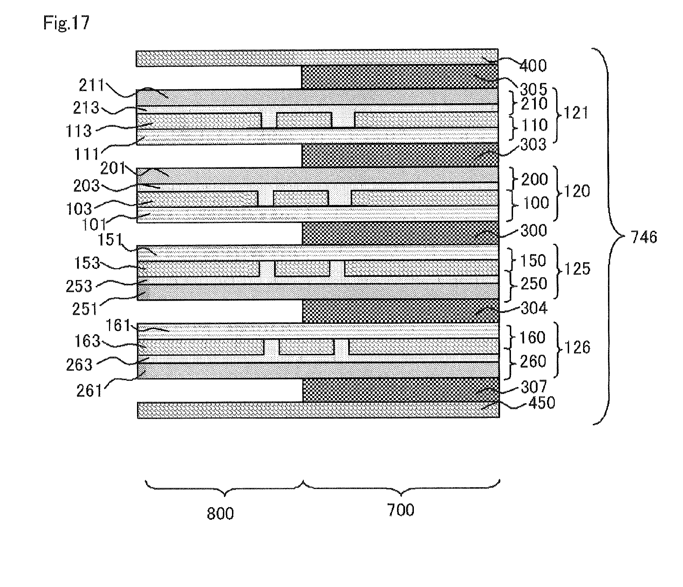

The rigid-flex circuit board 756 having the six-layered structure can be obtained by combining the first to the fourth embodiments. For example, the inner four-layered structure may be similarly formed to the third embodiment (with a circuit substrate added to the respective sides of the two-layered rigid-flex circuit board 750 according to the first embodiment).
First, as shown in Fig. 16, the metal foil 400 is located on the side of the third coverlay film 210 via a fifth interlayer adhesive sheet 305, and on the opposite side, i.e. on the side of the fourth coverlay film 260, a metal foil 450 is located via a sixth interlayer adhesive sheet 307.
The stacked structure as shown in Fig. 17 is subjected to heat-press bonding (Fig. 17). Through such process, the six-layered intermediate plate 746 can be obtained.

Then in the rigid portion 700, the metal foil 400, 450 at the outermost layer are subjected to an etching process or the like, to thereby form the conductor circuit 401, 450 (Fig. 18). The conductor circuit 401, 451 formed on the rigid portion 700 may have its surface covered with a surface coating layer 220, 270 (Fig. 18). It is to be noted that the conductor circuit 451 and the surface coating layer 270 constitute a first conductor circuit portion 145. Also, the surface coating layer 270 may be constituted of a resin film 271 and an adhesive 273.
In this process, the through hole 500 may be formed so as to penetrate through all the layers for electrical connection, as in the fourth embodiment. Also, it is preferable to entirely remove the metal foil 400, 450 in the region where the flexible portion 800 is to be formed, when forming the conductor circuit 401, 450 by etching or the like. Through such process, the rigid-flex circuit board 756 having the six-layered structure can be obtained.

By the manufacturing method of the rigid-flex circuit board according to the foregoing embodiments of the present invention, the respective materials constituting the rigid-flex circuit board are stacked in a predetermined order, and the stacked materials are collectively subjected to the heat-press bonding process. Such method minimizes the number of times of the heat-press bonding for the respective layers thereby suppressing the fluctuation in size between the layers, thus resulting in manufacturing the rigid-flex circuit board highly reliable in interlayer connection. Further, the manufacturing method of the rigid-flex circuit board, and the rigid-flex circuit board thereby manufactured contribute, with the advantage of reducing number of times of the heat-press bonding, to reducing the environmental impact, improving the yield, and reducing the man-hour.

For example, in the case of manufacturing the six-layered rigid-flex circuit board 756 shown in Fig. 18 by the conventional method, the circuit substrates 100, 110, 150, 160 have to be respectively located in position with the coverlay film 200, 210, 250, 260 and subjected to the heat-press bonding by the heat-press machine four times in total, in order to form the flexible circuit portions 120, 121, 125, 126. Accordingly, since the thermal histories from these heat-press bonding processes are all different, the flexible circuit portions 120, 121, 125, 126 thus formed also exhibit different dimensional behavior. Besides, the metal foils have to be further stacked on those layers and the heat-press bonding has to be executed with the heat-press machine. Consequently, a combination of substrates carrying five different thermal histories in total is formed, which incurs difficulty in properly positioning the flexible circuit portions 120, 121, 125, 126 when laminating these portions thereby forming the multilayer rigid-flex circuit board. This leads to degraded reliability and yield because of warp and dimensional deviation, and to an increase in cost.
In contrast, according to the embodiments of the present invention, the six-layered rigid-flex circuit board 756 can be formed through a single session of heat-press bonding with the heat-press machine. Such method allows easily forming a structure in which the flexible circuit portions 120, 121, 125, 126 of the rigid-flex circuit board 756 have the same thermal history. The structure thus formed is free from warp and dimensional deviation, and therefore reliable rigid-flex circuit boards can be manufactured at high yield. Further, the rigid-flex circuit board 756 can be offered at a low cost.

Based on the foregoing description of the manufacturing methods of the two-, three-, four-, and six-layered rigid-flex circuit board according to the embodiments, a desired multilayer rigid-flex circuit board can be obtained by combining a plurality of coverlay films and circuit substrates via an interlayer adhesive sheet.

The rigid-flex circuit board according to the present invention may be suitably employed in mobile phones, peripheral electric devices of personal computers, and so forth.

## Claims

1. A method of manufacturing a rigid-flex circuit board including a flexible portion and a rigid portion, comprising:
preparing a first circuit substrate having a first circuit formed on a surface thereof, a first coverlay film to be provided over said first circuit, a second circuit substrate having a second circuit on a surface thereof, a second coverlay film to be provided over said second circuit, and a first interlayer adhesive sheet;
placing said first circuit substrate and said first coverlay film on one side of said first interlayer adhesive sheet provided in a region where said rigid portion is to be formed, and said second circuit substrate and said second coverlay film on the other side of said first interlayer adhesive sheet; and
placing said first coverlay film on the side of said first circuit and said second coverlay film on the side of said second circuit, and collectively executing a heat-pressing process upon stacking said circuit substrates, said coverlay films and said interlayer adhesive sheet.

2. The method according to claim 1, comprising further preparing a third circuit substrate having a third circuit, a third coverlay film to be provided over said third circuit, and a third interlayer adhesive sheet;
placing said first circuit substrate, said first coverlay film, said third interlayer adhesive sheet, said third circuit substrate, and said third coverlay film in this order on one side of said first interlayer adhesive sheet provided in said region where said rigid portion is to be formed;
placing said second circuit substrate and said second coverlay film on the other side of said first interlayer adhesive sheet; and
placing said first and said third coverlay film on the side of said first and said third circuit, and said second coverlay film on the side of said second circuit, and collectively executing said heat-pressing process upon stacking said circuit substrates, said coverlay films and said interlayer adhesive sheets.

3. The method according to claim 2, comprising further preparing a fourth circuit substrate having a fourth circuit, a fourth coverlay film to be provided over said fourth circuit, and a fourth interlayer adhesive sheet;
placing said first circuit substrate, said first coverlay film, said third interlayer adhesive sheet, said third circuit substrate, and said third coverlay film in this order on one side of said first interlayer adhesive sheet provided in said region where said rigid portion is to be formed;
placing said second circuit substrate, said second coverlay film, said fourth interlayer adhesive sheet, said fourth circuit substrate, and said fourth coverlay film in this order on the other side of said first interlayer adhesive sheet; and
placing said first and said third coverlay film on the side of said first and said third circuit, and said second and said fourth coverlay film on the side of said second and said fourth circuit, and collectively executing said heat-pressing process upon stacking said circuit substrates, said coverlay films and said interlayer adhesive sheets.

4. The method according to claim 1, comprising further preparing a metal foil and a second interlayer adhesive sheet;
placing said first circuit substrate, said first coverlay film, said second interlayer adhesive sheet, and said metal foil in this order on one side of said first interlayer adhesive sheet provided in said region where said rigid portion is to be formed;
placing said second circuit substrate and said second coverlay film on the other side of said first interlayer adhesive sheet; and
placing said first coverlay film on the side of said first circuit and said second coverlay film on the side of said second circuit, and collectively executing a heat-pressing process upon stacking said circuit substrates, said coverlay films and said interlayer adhesive sheets.

5. The method according to claim 1, wherein said first interlayer adhesive sheet is a pre-preg constituted of a fiber base material impregnated with a resin component.

6. The method according to claim 5, wherein said fiber base material is a glass woven fabric.

7. The method according to claim 1, wherein said first interlayer adhesive sheet has a thickness equal to or more than 10 µm and equal to or less than 200 µm.

8. The method according to claim 1, wherein said preparing includes forming an opening in said first interlayer adhesive sheet, in a region where said flexible portion is to be formed.

9. The method according to claim 1, wherein said executing said heat-pressing process is followed by forming a through hole in said rigid portion.

10. A rigid-flex circuit board, obtained through said method of manufacturing according to claim 1.
